# EUROPEAN PATENT APPLICATION

(11) **EP 2 933 833 A1**
(43) Date of publication of application: **21.10.2015**
(21) Application number: 14305564.8
(22) Date of filing: 16.04.2014
(51) Int. Cl.: H01L 23/552, H01L 23/467, H05K 9/00

(54) **Electromagnetic shielding device**

(71) Applicant: Thomson Licensing, 92130 Issy-les-Moulineaux (FR)
(72) Inventor: Le Foulgoc, Jean-Marc, 35 576 Cesson Sévigné (FR); Morin, Pierre-Marie, 35 576 Cesson Sévigné (FR); Lo Hine Tong, Dommnique, 35 576 Cesson Sévigné (FR)
(74) Representative: Browaeys, Jean-Philippe

(57) **Abstract**

An electromagnetic shielding device for at least one electronic component of an electronic device, the shielding apparatus comprising: an electromagnetic shielding frame configured to restrict radiation of electromagnetic interference from at least one heat dissipation component of the electronic device; wherein the electromagnetic shielding frame is arranged, in use, to at least partially frame the at least one heat dissipation component and is provided with a plurality of resilient protrusions, biased in use, to contact against the at least one heat dissipation component to provide electrical contact with the at least one heat dissipation component.

## Description

### TECHNICAL FIELD

The present invention relates to an electromagnetic shielding device and a shielding apparatus comprising a heat sink and an electromagnetic shielding device.

### BACKGROUND

Electronic devices such as computer devices and wireless devices including mobile telephones, set-top boxes and gateway devices, contain electronic components which in use generate a significant amount of heat. Such components include, for example, integrated circuits (ICs) including silicon-based high-speed microprocessors and system-on-chips (SoC) which integrate millions of transistors generating, in use, significant amounts of heat. The generated heat should be dissipated to prevent overheating and consequent malfunctioning of the electronic device. As electronic devices become smaller in size, the density of heat dissipation increases. Heat sinks are typically provided on such devices to dissipate heat energy generated by electronic components. Some heat sinks are designed in the form of blades to increase surface area for thermal dissipation.

Another problem encountered in electronic devices is electromagnetic interference (EMI). Electronic components such as processors can generate electromagnetic radiation which can interfere with the functioning of electronic components of an electronic device. Such electromagnetic radiation is often referred to as electromagnetic interference and can interfere in particular with the operation of radio frequency (RF) components for wireless functions. Common mode currents present on processor chip, for instance, can generate EMI that occurs in the RF operating frequency range of RF modules, such as for example WiFi, DECT, RF4CE, Bluetooth, 3G/4G cellular network modules embedded in the same electronic device resulting in interference. The problem may be exacerbated in the case where the electronic component is provided with a heat sink in the form of blades. The blades act as antennae radiating the electromagnetic interference.

There is a need therefore for a system providing heat dissipation while restricting the radiation of electromagnetic interference. As wireless devices become increasingly reduced in size, the space taken up by such systems is becoming an increasing preoccupation. The present invention has been devised with the foregoing in mind.

### SUMMARY

According to a first aspect of the invention there is provided an electromagnetic shielding device for at least one electronic component of an electronic device, the electromagnetic shielding device comprising:
an electromagnetic shielding frame configured to restrict radiation of electromagnetic interference from at least one heat dissipation component of the electronic device;
wherein the electromagnetic shielding frame is arranged, in use, to at least partially frame the at least one heat dissipation component and is provided with a plurality of resilient protrusions, biased in use, to contact against the at least one heat dissipation component to provide electrical contact with the at least one heat dissipation component.

In an embodiment, the electromagnetic shielding frame is provided with at least one aperture configured to receive the heat dissipation component such that, in use, the heat dissipation component extends through the at least one aperture and wherein the resilient protrusions are provided at the edge of the at least one aperture to contact a surface of the heat dissipation component.

In an embodiment, the electromagnetic shielding is fixable to the component board of the electronic device by one or more push pins.

In an embodiment, a plurality of apertures are provided for framing a plurality of respective heat sinks.

According to a second aspect of the invention there is provided a shielding apparatus for shielding at least one electronic component of an electronic device, the shielding apparatus comprising:
a heat dissipation component arranged in thermal contact with at least one electronic component of the electronic device to enable dissipation of heat from said at least one electronic component;
and an electromagnetic shielding device according to any embodiment of the first aspect of the invention, for restricting radiation of electromagnetic interference from the heat dissipation component.

In an embodiment, the heat dissipation component is provided with a plurality of heat dissipating fins and the resilient protrusions are arranged to press against one or more of the heat dissipating fins.

A further aspect of the invention relates to an electronic device comprising a shielding apparatus in accordance with any embodiment of the second aspect of the invention. For example the electronic device may be a gateway or a set-top box.

A further aspect of the invention relates to a circuit board for an electronic device, the circuit board comprising a shielding apparatus in accordance with any embodiment of the second aspect of the invention.

### BRIEF DESCRIPTION OF THE DRAWINGS

Embodiments of the invention will now be described, by way of example only, and with reference to the following drawings in which:
FIG. 1 is a perspective view of an electromagnetic radiation shielding device in accordance with an embodiment of the invention;
FIG. 2A is a perspective view of a heat sink in accordance with one or more embodiments of the invention;
FIG. 2B is a perspective view of a shielding apparatus in accordance with an embodiment of the invention comprising the electromagnetic shielding device of Figure 1 and the heat sink of Figure 2A;
FIG. 2C is a side view of the shielding apparatus of FIG. 2B;
FIG. 3 is a perspective view of a shielding apparatus mounted on a PCB of an electronic device in accordance with an embodiment of the invention;
FIG. 4 is a perspective view of a shielding apparatus mounted on a PCB of an electronic device in accordance with another embodiment of the invention;
FIG. 5A is a perspective view of a shielding apparatus mounted on a PCB of an electronic device in accordance with another embodiment of the invention;
FIG. 5B is a perspective view of the shielding apparatus of FIG. 5A mounted in an electronic device;
FIG. 5C is another perspective view of the shielding apparatus of FIG. 5A mounted in an electronic device;
FIG. 6A is a perspective view of a shielding apparatus in accordance with a further embodiment of the invention; and
FIG. 6B is a side view of the shielding apparatus of Figure 6A.

### DETAILED DESCRIPTION

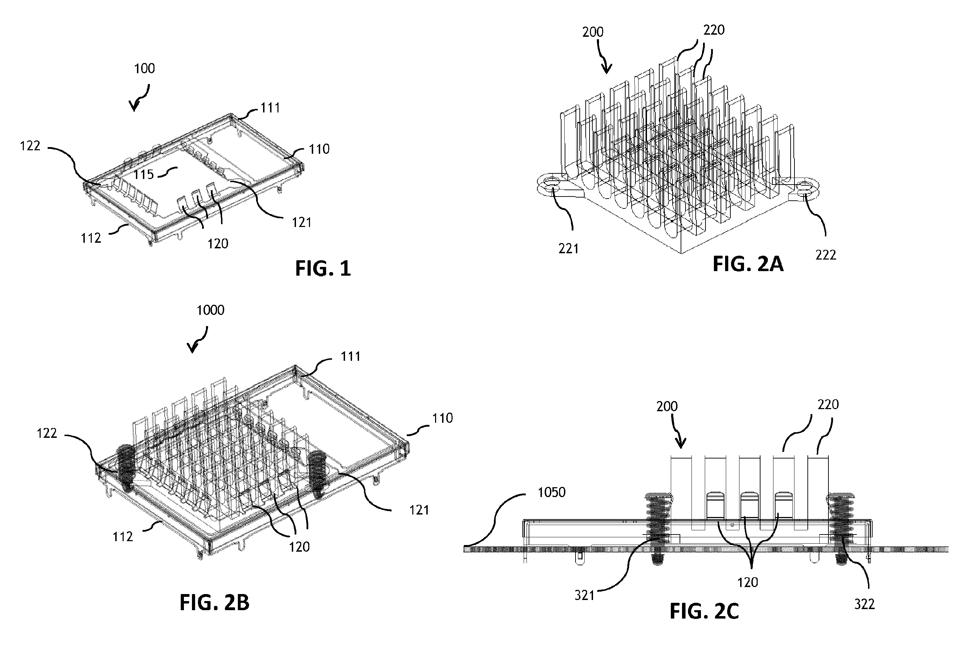

Figure 1 is a perspective view of an electromagnetic interference (EMI) shielding device in accordance with a first embodiment of the invention.

The EMI shielding device 100 comprises a metallic frame 110 provided with an opening 115 defined by an inner edge. The metallic frame is provided with a first surface 111 and an opposing second surface 112. Around the inner edge defining the opening 115 are provided a plurality of resilient metallic strips 120 protruding away from the first surface 111 and biased towards the opening 115. The metallic frame 110 is composed of a suitable electromagnetic shielding material, such as for example electrically conductive material such as aluminum, brass, copper, steel, copper beryllium alloy or phosphor bronze.

The function of the EMI shielding is to shield one or more electronic components of an electronic device, on which the EMI shielding device is mounted, from EMI emitted from other electronic components; or to restrict EMI from the electronic component(s) over which it is placed from interfering with other electronic components. In particular, the function is to minimize the radiation of EMI from a heat sink of the electronic device.

Two apertures 121 and 122 are provided, at diagonally opposing corners of the edge of the opening 115, to receive push pins to connect the EMI shielding device 100 to an electronic device containing the electronic components for which it is providing the EMI shielding. While in this embodiment, two push pin receiving apertures are provided, it will be appreciated that in other embodiments of the invention any number of receiving apertures may be provided.

Figure 2A is a perspective view of an example of a heat sink 200 according to one or more embodiments of the invention.

Figure 2B and Figure 2C illustrate a shielding apparatus 1000 in accordance with an embodiment of the invention comprising the EMI shielding device of Figure 1 mounted around the heat sink 200 of Figure 2A.

The heat sink 200 operates to dissipate heat energy from one or more electronic components with which it is in thermal contact. The heat sink comprises a contact portion on its underside for thermal contact with the electronic component(s) and a plurality of fins 220 for increasing the surface area for heat dissipation. In the example of Figure 2A the fins are configured as an array of protruding cuboid shaped fins. It will be appreciated that in the context of the invention the heat sink is not limited to the exemplified heat sink. In other embodiments of the invention, for example, the heat sink may be made up of a single heat fin or a plurality of fins arranged in a different configuration such as a row of fins. Moreover the heat fin(s) may be of any suitable shape for dissipating heat energy. The heat sink is formed of a material suitable for the transfer of heat energy from the electronic component with which it is thermal contact. The heat sink material may be a heat conductive metal such as, for example aluminum or any aluminum alloy. The heat sink is provided with two push pin receiving apertures 221 and 222, at diagonally opposing corners of the edge of the opening 115, to cooperate with the push pin receiving apertures 121 and 122 of the EMI shielding device to receive push pins to connect the shielding apparatus 1000 to a PCB of an electronic device

With reference to Figure 2B, the resilient strips 120 of the electromagnetic shielding device 100 are biased to press against the external fins 220 of the heat sink making electrical contact with the fins 220 such that electrical continuity is provided across the assembly of the heat sink 200 and the electromagnetic shielding device 100. The pressing of the resilient strips against the fins of the heat sink provide mechanical co-operation enabling simplified manufacture of the shielding apparatus since additional connecting components are not necessary.

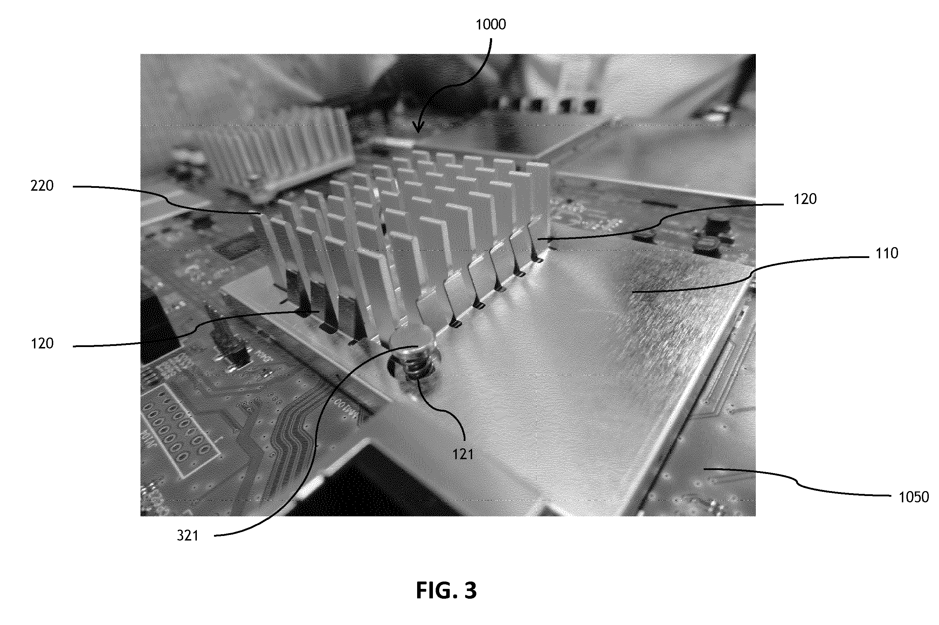

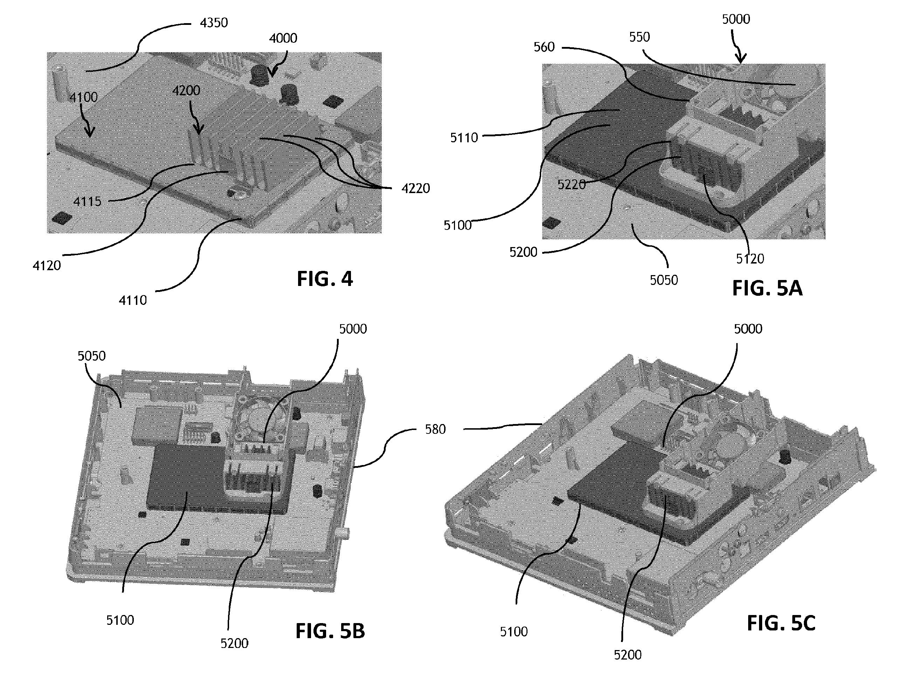

Figure 3 is a photographic view of the shielding apparatus 1000 mounted on a PCB of an electronic device, such as for example a set-top box or a gateway device. Push pins 321 and 322 extend through the push pin receiving apertures 121 and 122 of the EMI shielding device 100 , and the push pin receiving apertures 221 and 222 heat sink 200 to mount the shielding apparatus 1000 to a PCB 1050 of the electronic device. The push pins may be of metal or plastic material. The use of plastic material for the push pins helps to reduce unwanted resonance. Figure 4 is a perspective view of a shielding apparatus 4000 according to another embodiment of the invention mounted on the PCB of an electronic device, such as for example a set-top box or a gateway device. In the embodiment of Figure 4 the shielding apparatus 4000 comprises an EMI shielding device 4100 and a heat sink 4200. The heat sink 4200 is for dissipating heat energy from one or more electronic components with which it is in thermal contact and is provided with a plurality of heat dissipating fins 4220 arranged in rows parallel to one another, each row including one thin cuboid shaped fin 4220.The EMI shielding device 4100 comprises a metallic frame 4110 provided with an opening 4115 defined by an inner edge. The metallic frame is similar to the metallic frame of the first embodiment. Two resilient metallic strips 4120 is provided on the metallic frame 4110 at opposing sides of the opening 4115 protruding away from the surface of the frame 4110 and biased towards the opening 4115 to press against a plurality of heat dissipating fins 4220. The resilient metallic strips 4120 are arranged perpendicular to the rows of heat dissipating fins 4220 such that each resilient strip 4120 contacts a plurality of resilient metallic strips from adjacent rows such that electrical continuity is provided across the assembly of the heat sink 4200 and the electromagnetic shielding device 4100.

In some embodiments of the invention the heat sink may be provided with an electric fan 550 to increase the rate of heat dissipation. Figure 5A is a perspective view of a shielding apparatus 5000 mounted on the PCB 5050 of an electronic device. The electric fan 550 is mounted over the heat dissipation sink 5200 which is similar to the heat sink 4200 of Figure 4, and is supported by a plastic support structure 560. In this embodiment the heat sink 5200 comprises a row of parallel heat dissipation fins 5220. The electromagnetic shielding device 5100 is similar to the EMI shielding device of Figure 4 and comprises a frame 5110 and a resilient blade 5120 located at each side edge of the aperture through which the heat sink 5200 extends. Each resilient blade 5120 is resiliently biased against fins of the heat sink 5200, to provide electrical contact with the heat sink 5200.

Components of the electronic device which are typically shielded include ICs such as CPUs, SoCs and the like.

Embodiments of the invention may be used in electronic devices, such as set-top-boxes and gateways, which integrate wireless modules that have to coexist with high power electronic components while being immune to EMI from the high power electronic components. For example, Figures 5B and 5C are perspective view of the shielding apparatus of Figure 5A mounted on a PCB in a set top box 580 and arranged over high power electronic components (not shown).

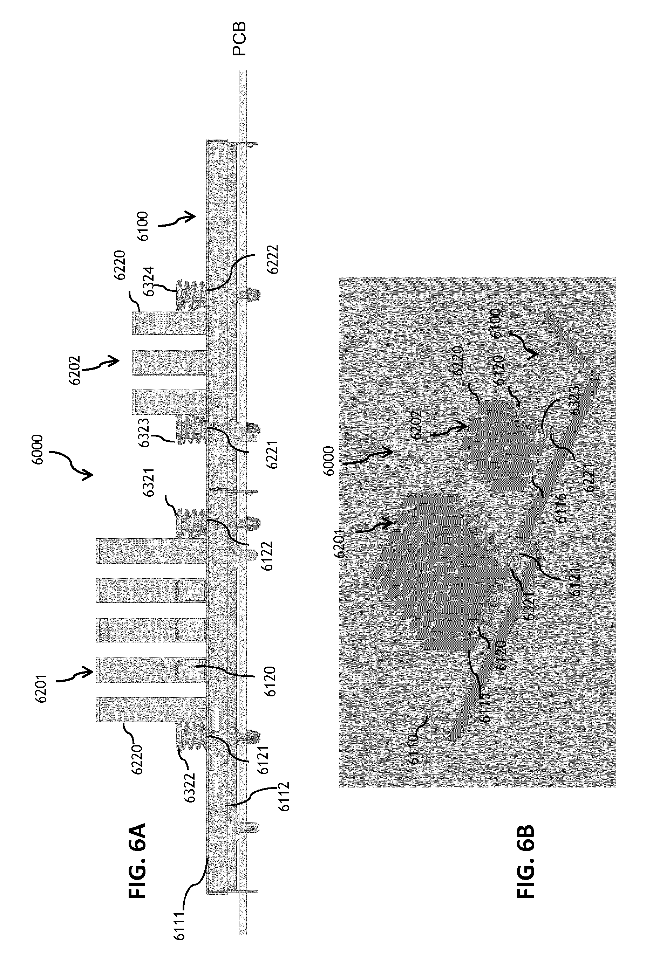

Figures 6A and 6B illustrate a shielding apparatus according to a further embodiment of the invention. In the embodiment of Figures 6A and 6B, the shielding apparatus 6000 comprises an EMI shielding device 6100 and two heat sinks 6201 and 6202.

The EMI shielding device 6100 comprises a metallic frame 6110 provided with two openings 6115 and 6116, each opening defined by an inner edge and configured to frame a respective heat sink 6201, 6202. The metallic frame 6110 is provided with a first surface 6111 and an opposing second surface 6112.

Around each inner edge defining the first heat sink opening 6115 are provided a plurality of resilient metallic strips 6120 protruding away from the first surface 6111 and biased towards the opening 6115. A plurality of resilient metallic strips 6120 are provided on a pair of opposing edges of the second heat sink opening. The resilient strips protrude away from the first surface 6111 and are biased towards the second opening 6116.

The metallic frame 6110 is composed of a suitable electromagnetic shielding material, similar to the previous embodiments of the invention.

The function of the EMI shielding is to shield one or more electronic components of an electronic device, on which the EMI shielding device is mounted, from EMI emitted from other electronic components; or to restrict EMI from the electronic component(s) over which it is placed from interfering with other electronic components. In particular, the function is to minimize the radiation of EMI from the two heat sinks 6201, 6202.

A pair of push pin apertures 6121 and 6122, 6221, 6222 for push-pins 6322, 6321, 6323, 6324 are provided, at diagonally opposing corners of the edges of each opening 6115 and 6116, to each receive push pins to connect the EMI shielding device 6100 to an electronic device containing the electronic components for which it is providing the EMI shielding. While in this embodiment, a pair of push pin receiving apertures are provided at each heat sink receiving opening 6115 and 6116, it will be appreciated that in other embodiments of the invention any number of push-pin receiving apertures may be provided.

Each heat sink 6201, 6202 operates in a similar way to the heat sink of the first embodiment of the invention to dissipate heat energy from one or more electronic components with which it is in thermal contact. Each heat sink 6201, 6202 comprises a contact portion 6210 on its underside for thermal contact with the electronic component(s) and a plurality of fins 6220 for increasing the surface area for heat dissipation. As in the first embodiment the heat dissipating fins 6220 of each heat sink 6201 6202 are configured as an array of protruding cuboid shaped fins. Each heat sink is formed of a material suitable for the transfer of heat energy from the electronic component with which it is thermal contact.

The resilient strips 6120 of the electromagnetic shielding device 6100 are biased to press against the external fins 6220 of the heat sinks making electrical contact with the fins 6220 such that electrical continuity is provided across the assembly of the two heat sinks 6201 and 6202, and the electromagnetic shielding device 6100.

A significant amount of EMI is radiated by the heat sinks of IC processors. Embodiments of the invention help to restrict the radiation of EMI from such heat sinks thereby ensuring better performance of wireless modules in the electronic devices.

Furthermore, the proposed simplified approach in particular the co-operation between the heat sink and the shielding device enables the mechanical components; of to be manufactured at reduced cost, using the most common manufacturing technologies.

Although the present invention has been described hereinabove with reference to specific embodiments, the present invention is not limited to the specific embodiments, and modifications will be apparent to a skilled person in the art which lie within the scope of the present invention.

For instance, while the foregoing examples have been described with respect to shielding devices comprising a single EMI shield and one or two heat sinks it will be appreciated that a EMI shield may be designed to operate with any number of heat sinks or any shape of heat sink.

Many further modifications and variations will suggest themselves to those versed in the art upon making reference to the foregoing illustrative embodiments, which are given by way of example only and which are not intended to limit the scope of the invention, that being determined solely by the appended claims. In particular the different features from different embodiments may be interchanged, where appropriate.

## Claims

1. An electromagnetic shielding device for at least one electronic component of an electronic device, the electromagnetic shielding device comprising:
an electromagnetic shielding frame configured to restrict radiation of electromagnetic interference from at least one heat dissipation component of the electronic device;
wherein the electromagnetic shielding frame is arranged, in use, to at least partially frame the at least one heat dissipation component and is provided with a plurality of resilient protrusions, biased in use, to contact against the at least one heat dissipation component to provide electrical contact with the at least one heat dissipation component.

2. An electromagnetic shielding device according to claim 1 wherein the electromagnetic shielding frame is provided with at least one aperture configured to receive the heat dissipation component such that, in use, the heat dissipation component extends through the at least one aperture and wherein the resilient protrusions are provided at the edge of the at least one aperture to contact a surface of the heat dissipation component.

3. An electromagnetic shielding device according to claim 1 or 2 wherein the electromagnetic shielding is fixable to the component board of the electronic device by one or more push pins.

4. An electromagnetic shielding device according to any preceding claim provided with a plurality of apertures for framing a plurality of respective heat sinks.

5. A shielding apparatus for shielding at least one electronic component of an electronic device, the shielding apparatus comprising:
a heat dissipation component arranged in thermal contact with at least one electronic component of the electronic device to enable dissipation of heat from said at least one electronic component;
and an electromagnetic shielding device according to any preceding claim, for restricting radiation of electromagnetic interference from the heat dissipation component.

6. A shielding apparatus according to any preceding claim wherein the heat dissipation component is provided with a plurality of heat dissipating fins and the resilient protrusions are arranged to press against one or more of the heat dissipating fins.

7. An electronic device comprising a shielding apparatus in accordance with any one of claims 5 to 6.

8. An electronic device according to claim 7 comprising a gateway or a set-top box.

9. A circuit board for an electronic device, the circuit board comprising a shielding apparatus in accordance with any one of claims 5 to 6.
